# DEMANDE DE BREVET EUROPEEN

(11) **EP 3 591 709 A1**
(43) Date de publication de la demande: **08.01.2020**
(21) Numéro de dépôt: 19182675.9
(22) Date de dépôt: 26.06.2019
(51) Int. Cl.: H01L 29/778, H01L 29/78, H01L 29/40, H01L 29/417, H01L 29/861, H01L 29/06, H01L 29/20

(54) **TRANSISTOR A HETEROJONCTION DE TYPE NORMALEMENT OUVERT A RESISTANCE DE PASSAGE REDUITE**

(30) Priorité: 03.07.2018 FR 1856111
(71) Demandeur: Commissariat à l'Énergie Atomique et aux Énergies Alternatives, 75015 Paris (FR)
(72) Inventeur: BAINES, Yannick, 38054 GRENOBLE Cedex 09 (FR); BUCKLEY, Julien, 38054 GRENOBLE Cedex 09 (FR); ESCOFFIER, René, 38054 GRENOBLE Cedex 09 (FR)
(74) Mandataire: Guérin, Jean-Philippe

(57) **Abrégé**

L'invention concerne un transistor à effet de champ à hétérojonction (1) de type normalement ouvert, comprenant :
-une superposition d'une première couche de type III-N (11) et d'une deuxième couche de type III-N (12), de façon à former une couche de gaz d'électrons (13);

Comprenant en outre :
-un empilement d'une troisième couche, à dopage de type N (151) en contact électrique avec la deuxième couche, et d'une quatrième couche, à dopage de type P (152) disposée en contact sur la troisième couche ;
-une première électrode conductrice (14) et une deuxième électrode conductrice (15) en contact électrique avec la couche de gaz d'électrons (13) ;
-une couche de diélectrique (161) disposée contre une face latérale (150) de la quatrième couche (152) ;
-une électrode de commande (16) séparée de la face latérale (150) de la quatrième couche (152) par la couche de diélectrique (161).

## Description

L'invention concerne les composants électroniques à hétéro jonction, et en particulier les transistors à hétérojonction de type normalement ouvert.

De nombreuses applications électroniques nécessitent dorénavant une amélioration de performances surtout dans l'électronique embarquée à destination de l'automobile et des transports terrestres, dans l'aéronautique, dans les systèmes médicaux ou dans des solutions domotiques par exemple. Ces applications nécessitent pour la plupart des commutateurs pour forte puissance fonctionnant dans des gammes de fréquences fréquemment supérieures au megahertz.

Une alternative pour des commutateurs de puissance, notamment à hautes fréquences, est l'utilisation de transistors à effet de champ à haute mobilité d'électrons, également désignés par le terme de transistor à effet de champ à hétérostructure. Un tel transistor inclut la superposition de deux couches semi-conductrices ayant des bandes interdites différentes qui forment un puit quantique à leur interface. Des électrons sont confinés dans ce puits quantique pour former un gaz bidimensionnel d'électrons. Pour des raisons de tenue en haute tension et en température, ces transistors sont choisis de façon à présenter une large bande d'énergie interdite.

Parmi les transistors HEMT à large bande d'énergie interdite, les transistors à base de nitrure de gallium sont très prometteurs. Leur largeur de bande d'énergie interdite induit un champ électrique critique plus élevé comparé aux matériaux classiques de l'électronique, une vitesse de saturation élevée des porteurs et de bonnes stabilités thermique et chimique. Le champ de claquage du nitrure de gallium peut ainsi être supérieur à 2x10⁶ V/cm, ce qui permet aisément de réaliser des transistors compacts avec des tensions de claquage supérieures à 600 V. Avec un transistor à conduction latérale, la tension de claquage grille/drain peut aisément être contrôlée par une distance appropriée entre grille et drain. De plus, de tels transistors permettent de très grandes densités de courant du fait de la très grande mobilité électronique et de la forte densité électronique dans le gaz d'électrons d'interface.

Le document US20090278172 décrit une structure présentant une superposition d'un substrat, d'une couche tampon, d'une couche de GaN et d'une couche d'AlGaN sur la couche de GaN. Une couche de gaz d'électrons est formée à l'interface entre les couches de GaN et d'AlGaN. Une électrode de drain et une électrode de source sont disposées de part et d'autre d'une grille. Une tranchée est formée à travers la couche d'AlGaN, de sorte que la couche de gaz d'électrons est localement interrompue, rendant le transistor de type normalement ouvert. Un empilement d'une couche de diélectrique et d'une couche métallique de grille est disposé dans la tranchée. La source est disposée sur un empilement d'une couche de GaN dopée de type N présente sur la couche d'AlGaN, d'une couche d'InGaN formée sur la couche de GaN de type N, et d'une autre couche de GaN de type N formée sur la couche d'InGaN de type N. L'empilement de grille déborde sur une face latérale de l'empilement des couches de GaN type N et de InGaN de type P.

Un tel transistor présente des inconvénients. Ainsi, le transistor présente une résistance relativement élevée à l'état passant.

L'invention vise à résoudre un ou plusieurs de ces inconvénients. L'invention porte ainsi sur un transistor à effet de champ à hétérojonction de type normalement ouvert, tel que défini dans les revendications annexées.

L'invention porte également sur les variantes des revendications dépendantes. L'homme du métier comprendra que chacune des caractéristiques de la description ou des revendications dépendantes peut être combinée indépendamment aux caractéristiques d'une revendication indépendante, sans pour autant constituer une généralisation intermédiaire.

D'autres caractéristiques et avantages de l'invention ressortiront clairement de la description qui en est faite ci-après, à titre indicatif et nullement limitatif, en référence aux dessins annexés, dans lesquels :
- la figure 1 est une vue en coupe schématique d'un exemple de transistor à hétérojonction de type normalement ouvert selon un exemple d'un premier mode de réalisation de l'invention ;
- la figure 2 illustre le chemin de conduction entre deux électrodes de conduction lorsque le transistor de la figure 1 est à l'état passant ;
- la figure 3 est une vue en coupe schématique d'un exemple de cellule incluant deux transistors à hétérojonction selon un exemple d'un deuxième mode de réalisation de l'invention ;
- la figure 4 est une vue en coupe schématique d'un exemple de transistor à hétérojonction de type normalement ouvert selon un exemple d'un troisième mode de réalisation de l'invention ;
- la figure 5 est une vue en coupe d'une variante d'un empilement de couches semi-conductrices pour former un canal d'un transistor selon l'invention ;
- les figures 6 et 7 sont des vues en coupe d'un exemple de transistor à hétérojonction de type normalement ouvert selon un exemple d'un quatrième mode de réalisation de l'invention.

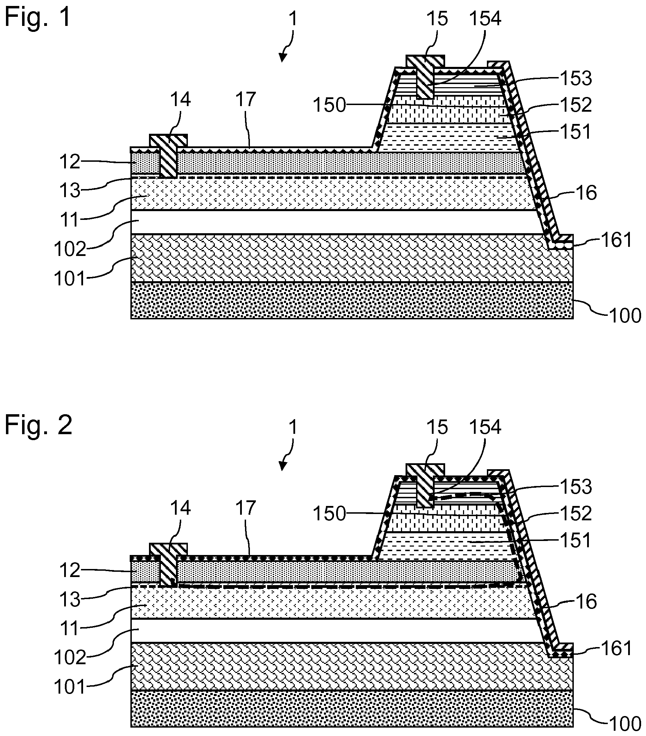

La figure 1 est une vue en coupe schématique d'un exemple de transistor 1 à hétérojonction de type normalement ouvert selon un exemple d'un premier mode de réalisation de l'invention. Le transistor 1 comprend une couche barrière 12. La couche barrière 12 est ici formée sur une couche de canal 11, de façon à former une couche de gaz d'électrons 13 au niveau de l'interface entre les couches 11 et 12. Dans un souci de lisibilité, le gaz d'électrons est illustré sous forme d'une couche 13. La couche 11 est ici avantageusement formée sur un empilement de couches donné à titre illustratif. La couche 11 est ici formée sur une couche barrière enterrée 102. La couche 102 est formée sur une couche de piégeage de charges 101. La couche de piégeage de charges 101 est formée sur un substrat 100. Le substrat 100 peut être surmonté d'une couche d'adaptation et/ou d'une couche tampon, non illustrées ici.

Le substrat 100 présente une structure connue en soi. Le substrat 100 peut être un isolant ou un semi-conducteur de type silicium intrinsèque ou dopé, ou du SiC, du saphir ou même de l'AlN. Le substrat 100 peut typiquement présenter une épaisseur de l'ordre de 350 µm à 1,5mm.

Une couche d'adaptation non illustrée peut être interposée entre le substrat 100 et la couche de piégeage de charges 101. La couche 101 est par exemple en GaN dopé Carbone ou inclut des couches AlₓGa₍₁₋ₓ₎N ou d'autres couches de nitrure.

La couche 102 est par exemple formée en GaN à dopage de type P. La couche 102 présente par exemple une épaisseur de l'ordre de 100 nm. La couche 102 présente par exemple une concentration en magnésium compris entre 10¹⁷ cm⁻³ et 6^{∗}10¹⁷ cm⁻³, par exemple de 5^{∗}10¹⁷ cm⁻³.

La couche de canal 11 peut être formée de façon connue en soi en matériau semi-conducteur de type III-N, par exemple en GaN de type non intentionnellement dopé. Cette couche 11 peut par exemple présenter une épaisseur comprise entre 50 et 150 nm, par exemple de 100 nm.

La couche barrière 12 peut être formée de façon connue en soi en matériau semi-conducteur de type III-N, pour former la couche de gaz d'électrons 13 au niveau de son interface avec la couche de canal 11. La couche barrière est par exemple en AlₓGa₍₁₋ₓ₎N, en InAlN, en InGaAlN ou en AlN, avec une bande interdite supérieure à celle du matériau de la couche 11. La couche 12 est de type non intentionnellement dopé. La couche 12 peut par exemple présenter une épaisseur comprise entre 20 et 30 nm, par exemple de 25 nm. Une couche de matériau semi-conducteur peut être interposée entre les couches 11 et 12, par exemple une couche d'AlN d'une épaisseur de 1 à 2 nm.

Le transistor 1 comporte une électrode de conduction 14, en contact électrique avec la couche de gaz d'électrons 13. L'électrode 14 s'étend ici à travers la couche 12, jusqu'en contact avec la couche 11.

Un empilement de couches 151 à 153 est formé sur la couche 12. Cet empilement est distant de l'électrode de conduction 14. L'empilement est ici isolé électriquement de l'électrode 14 par l'intermédiaire d'une couche de diélectrique 17. La couche de gaz d'électrons 13 s'étend en continu de l'électrode 14 jusqu'à la verticale de l'empilement et de la couche 151.

L'empilement comporte :
- une couche en matériau semi-conducteur 151 de type N, disposée sur la couche 12. La couche 151 est par exemple en alliage de GaN. La couche 151 présente par exemple une épaisseur comprise entre 80 et 150 nm, par exemple de 100 nm. La concentration en dopant de type N est par exemple inférieure à 10¹⁸ cm⁻³ ; La jonction couche 153/couche 152/couche 151 se comportant comme un transistor MOS renversé avec une grille verticale, l'épaisseur de la couche 151 permet de définir la tension de claquage de ce transistor MOS ;
- une couche en matériau semi-conducteur 152 de type P, disposée en contact sur la couche 151. La couche 152 est par exemple en alliage de GaN. La couche 152 présente par exemple une concentration en magnésium comprise entre 10¹⁷ cm⁻³ et 8^{∗}10¹⁷ cm-³, par exemple de 7^{∗}10¹⁷ cm⁻³. La couche 152 peut par exemple présenter une épaisseur comprise entre 150 et 250 nm, par exemple de 200 nm;
- une couche en matériau semi-conducteur 153 de type N, disposée en contact sur la couche 152. La couche 153 est par exemple en alliage de GaN. La couche 153 présente par exemple une épaisseur comprise entre 15 nm et 70 nm, par exemple de 50 nm. La concentration en dopant de type N est par exemple 10¹⁸ cm⁻³. Avantageusement, la concentration en dopant de type N dans la couche 153 est supérieure à celle de la couche 151, de façon à réduire la résistance de contact de l'électrode 15.

Le transistor 1 comporte une électrode de conduction 15, en contact électrique avec la couche 152. L'électrode 15 est séparée de la couche 151 par au moins une partie de la couche 152. Dans cet exemple, l'électrode 15 est disposée sur la couche 153. L'électrode 15 s'étend ici jusqu'en contact avec la couche 152. L'électrode 15 comporte ici une partie 154 traversant la couche 153 et s'étendant jusque dans la couche 152. Avec une telle configuration, on garantit d'une part un meilleur contrôle électrostatique du canal de conduction formé à l'état passant. De plus, cette configuration permet de former une diode de roue libre entre les électrodes 14 et 15. Dans les modes de réalisation illustrés, la couche en matériau semi-conducteur 153 n'est qu'optionnelle.

Le transistor 1 comporte une couche de diélectrique 161, disposée notamment contre une face latérale 150 de la couche 152. La couche de diélectrique 161 est ici confondue avec la couche de diélectrique 17. La couche 161 est par exemple réalisée en Al₂O₃, et présente par exemple une épaisseur de 60 nm. La couche de diélectrique 161 est ici recouverte par une grille conductrice 16. La longueur de grille peut par exemple être de 15 µm, ou encore de 5 µm.

L'électrode de conduction 15 est ici disposée entre l'électrode de conduction 14 et la grille 16. Une telle configuration permet d'accroître la tension de claquage du transistor 1. On peut par exemple prévoir une distance d'au moins 10 µm entre l'électrode 15 et l'électrode 14, et de préférence d'au moins 15µm. Une telle configuration permet de supporter 650V soit un champ moyen de 0,6 MV/cm. Une telle configuration permet également de réaliser le transistor 1 de type normalement ouvert nativement de façon cascode monolithique, pouvant embarquer une diode de roue libre efficace.

Du fait de l'utilisation d'une couche 12 de type non intentionnellement dopée, on évite un risque de diffusion de porteurs de type N. On ne dégrade ainsi pas la mobilité de la couche de gaz d'électrons. Du fait de l'utilisation d'une couche non intentionnellement dopée, on bénéficie également d'une tenue en tension dans l'épaisseur de la couche 12 et pas seulement au niveau de la jonction p-n. Selon une telle configuration, la résistivité à l'état passant est également moindre.

La grille 16 est ici formée dans une tranchée 18, s'étendant à travers la couche 12. La tranchée 18 s'étend avantageusement jusqu'à l'interface entre la couche 11 et la couche 12. La tranchée 18 peut avantageusement s'étendre dans la couche 11 sur une profondeur d'au moins 10 nm, voire à travers la couche 11 : cela permet de réaliser un contrôle électrostatique continu sur tout le canal de conduction. La tranchée 18 s'étend ici à travers la couche 102 et jusque dans la couche 101. La couche de diélectrique 161 est donc ici également formée contre une face latérale de la couche 151, contre une face latérale de la couche 153, contre une face latérale de la couche 12, contre une face latérale de la couche 11 et contre une face latérale de la couche 102. Une telle configuration de la grille 16 permet notamment d'assurer le contrôle électrostatique dans la couche 12, en particulier si celle-ci est en AlGaN, matériau relativement peu conducteur à l'état passant. La couche 161 est disposée entre la grille 16 et les faces latérales des couches 151, 153, 12, 13 et 102.

En l'absence de polarisation sur la grille 16, le transistor MOS formé par la combinaison des couches 151 à 153 est bloqué à Vgs= 0 V. Le transistor 1 bloque alors le passage du courant et se comporte donc comme un transistor normalement ouvert.

La figure 2 illustre le transistor 1 à l'état passant. Par une polarisation appropriée sur la grille 16, la couche 152 est inversée au niveau de sa face latérale 150, recouverte par la couche de diélectrique 161 et en vis-à-vis de la grille 16. Le chemin de conduction se poursuit à travers les couches 151 et 12, jusqu'à la couche de gaz d'électrons 13. Du fait de la continuité de la couche de gaz électrons entre l'électrode 14 et la verticale de l'empilement, et en particulier la verticale de la face latérale 150, une très faible résistance à l'état passant est obtenue, et la tension de claquage entre les électrodes 14 et 15 s'avère particulièrement élevée.

Par ailleurs, alors que l'on pourrait craindre que la couche 152 à dopage de type P induise une déplétion de la couche de gaz d'électrons 13, la présence de la couche 151 à dopage de type N réduit sensiblement cet effet de déplétion, tout en apportant un supplément de tenue en tension à travers l'empilement.

Le transistor 1 du premier mode de réalisation inclut une couche 153 à dopage de type N, qui favorise la création d'un contact électrique avec l'électrode 15 et facilite l'inversion dans la couche 152 pour la rendre conductrice à l'état passant.

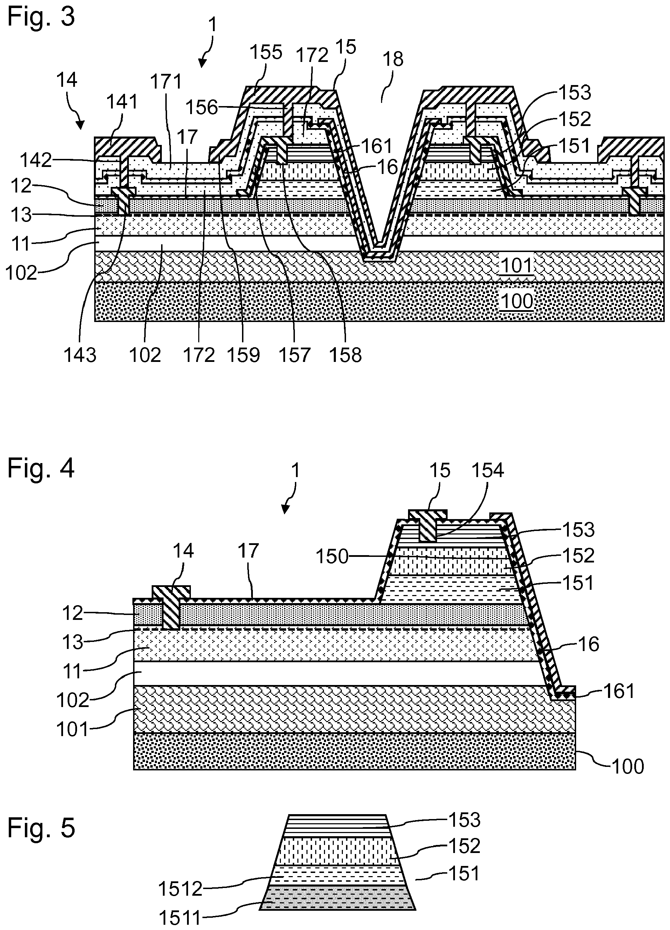

La figure 3 est une vue en coupe schématique d'un exemple de cellule incluant deux transistors à hétérojonction selon un exemple d'un deuxième mode de réalisation de l'invention. Deux transistors 1 sont ménagés de façon symétrique de part et d'autre d'une grille 16 commune. Chaque transistor 1 reprend les couches 100, 101, 102 ,11 et 12 du premier mode de réalisation. Chaque transistor 1 de ce deuxième mode de réalisation reprend également l'empilement des couches 151, 152 et 153 du premier mode de réalisation.

L'électrode 14 comporte ici une partie inférieure identique à l'électrode 14 du premier mode de réalisation. L'électrode 14 traverse la couche 12 jusqu'en contact avec la couche 11. La couche de diélectrique 17 est ici dissociée de l'isolant de grille 161. Une première partie de l'électrode 15 présente une configuration identique à celle du premier mode de réalisation et traverse la couche 153 jusqu'en contact avec la couche 152. L'électrode 15 comporte ici un prolongement latéral 157 ou plaque de champ, disposé en vis-à-vis d'une face latérale des couches 151, 152 et 153, face latérale qui est opposée à la face latérale de ces couches 151, 152 et 153 qui est en vis-à-vis de la grille 16. Une telle configuration de l'électrode 15 permet de faciliter une commutation vers l'état ouvert du transistor 1, de former un écran électromagnétique et de lisser le champ électromagnétique généré.

Les électrodes 14 et 15 et la couche de diélectrique 17 sont recouvertes par une première couche de passivation 172. La première couche de passivation 172 est recouverte par un prolongement latéral de l'isolant de grille 161. L'isolant de grille 161 et la grille 16 sont recouvertes par une seconde couche de passivation 171.

L'électrode 14 comporte une partie supérieure 141 disposée à la verticale d'une partie inférieure 143 et positionnée sur une partie de la seconde couche de passivation 171. L'électrode 14 comporte par ailleurs un via 142 reliant la partie supérieure 141 et la partie inférieure 143. Le via 142 traverse ainsi les couches de passivation 171 et 172 et l'isolant de grille 161. Avantageusement, la projection orthogonale de la partie supérieure 141 de l'électrode 14 sur la couche 12 inclut la projection de la partie inférieure 143 sur la couche 12.

L'électrode 15 comporte une partie supérieure 155 disposée à la verticale d'une partie inférieure 158 et positionnée sur une partie de la seconde couche de passivation 171. La partie supérieure 155 comporte une partie 159 s'étendant latéralement en direction de l'électrode 14, pour former une plaque de champ. Par rapport à la plaque de champs 157, la plaque de champ 159 s'étend en saillie d'une distance de 50 nm en direction de l'électrode 14. La partie supérieure 155 recouvre également la grille 16. Défini autrement, la projection orthogonale de la partie supérieure 155 de l'électrode 15 sur la couche 12 inclut la projection de la partie inférieure 158 sur la couche 12. La partie supérieure 155 est séparée de la grille 16 par l'intermédiaire de la seconde couche de passivation 171. L'électrode 15 comporte par ailleurs un via 156 reliant la partie supérieure 155 et la partie inférieure 158. Le via 156 traverse ainsi les couches de passivation 171 et 172 et l'isolant de grille 161.

La figure 4 est une vue en coupe schématique d'un exemple de transistor 1 à hétérojonction de type normalement ouvert selon un exemple d'un troisième mode de réalisation de l'invention. Le transistor 1 de la figure 4 reprend sensiblement toutes les caractéristiques structurelles et géométriques du transistor 1 de la figure 1. Le transistor 1 de la figure 4 diffère de celui de la figure 1 uniquement par son électrode 15 qui ne s'étend pas jusqu'en contact avec la couche 152. Une partie de la couche 153 à la verticale de l'électrode 15 forme ici une séparation entre l'électrode 15 et la couche 152.

La figure 5 est une vue en coupe schématique d'un empilement des couches 151 à 153 selon une variante de l'invention. Dans cette configuration, la couche 151 comprend un premier film 1511 en contact avec la couche 12, et un deuxième film 1512 disposé entre le film 1511 et la couche 152. Le film 1511 présente une concentration en dopant de type N supérieure à celle du film 1512. Le film 1511 présente avantageusement une épaisseur inférieure à celle du film 1512, typiquement une épaisseur de l'ordre de 10nm. Une telle configuration permet d'éviter que la couche 151 n'ait tendance à dépléter la couche de gaz d'électrons 13, tout en fournissant un réservoir d'électrons relativement important pour alimenter un canal d'inversion lors de la commutation du transistor 1 vers l'état passant.

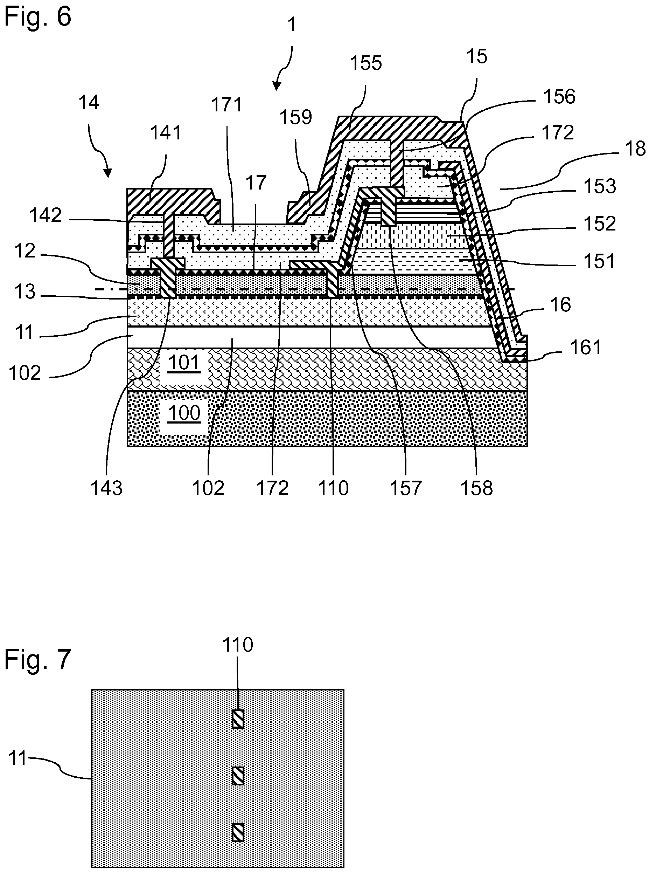

Les figures 6 et 7 sont des vues en coupe schématiques d'un exemple de transistor 1 à hétérojonction de type normalement ouvert selon un exemple d'un quatrième mode de réalisation de l'invention. La figure 7 est une vue en coupe de dessus au niveau de la ligne en tiret-point de la figure 6. Le transistor 1 de la figure 6 présente sensiblement la même configuration que les transistors 1 du deuxième mode de réalisation. L'électrode 15 comporte ici un prolongement latéral 157, présentant un ou plusieurs contacts Schottky 110 s'étendant à travers la couche de diélectrique 17 et à travers la couche de matériau semi-conducteur 12. On forme ainsi une diode de roue libre se déclenchant lorsque l'électrode 14 est polarisée négativement par rapport à électrode 15, avec un seuil indépendant de l'état de polarisation de la grille de commande 16. Un écran est formé au niveau des contacts Schottky 110, par une saillie métallique latérale sur la couche de diélectrique 17. On forme ainsi une diode de roue libre cascodée. Comme pour l'exemple de figure 3, la partie supérieure 155 comporte une partie 159 s'étendant latéralement en direction de l'électrode 14, pour former une plaque de champ.

Comme illustré à la figure 7, afin de de ne pas perturber excessivement la couche de gaz d'électrons 13, les contacts 110 sont localisés et n'interrompent pas la continuité de la couche 12 entre l'électrode et la verticale de l'empilement des couches 151 à 153. Dans l'exemple illustré, de tels contacts Schottky 110 sont avantageusement combinés avec les diodes de roue libre formée par la partie de l'électrode 15 en contact avec la couche 152.

## Revendications

1. Transistor à effet de champ à hétérojonction (1) de type normalement ouvert, comprenant :
- une superposition d'une première couche de matériau semi-conducteur, de type III-N (11) et d'une deuxième couche de matériau semi-conducteur, de type III-N (12), de façon à former une couche de gaz d'électrons (13) au niveau d'une interface entre les première et deuxième couches de matériau semi-conducteur ; **Caractérisé en ce qu'**il comprend en outre :
- un empilement d'une troisième couche de matériau semi-conducteur, à dopage de type N (151) en contact électrique avec la deuxième couche de matériau semi-conducteur, et d'une quatrième couche de matériau semi-conducteur, à dopage de type P (152) disposée en contact sur la troisième couche de matériau semi-conducteur ;
- une première électrode conductrice (14) en contact électrique avec la couche de gaz d'électrons (13) ;
- une deuxième électrode conductrice (15), en contact électrique avec la quatrième couche de matériau semi-conducteur (152) et séparée de la troisième couche de matériau semi-conducteur (151) par au moins une partie de la quatrième couche de matériau semi-conducteur (152) ;
- une couche de diélectrique (161) disposée contre une face latérale (150) de la quatrième couche de matériau semi-conducteur (152) ;
- une électrode de commande (16) séparée de la face latérale (150) de la quatrième couche de matériau semi-conducteur (152) par la couche de diélectrique (161), ladite deuxième électrode conductrice (15) étant positionnée entre la première électrode (14) et ladite électrode de commande (16), l'électrode de commande (16) s'étendant jusque dans une tranchée (18) traversant la deuxième couche de matériau semi-conducteur (12), ladite deuxième couche de matériau semi-conducteur étant de type non intentionnellement dopé.

2. Transistor à effet de champ à hétérojonction (1) selon la revendication 1, dans lequel ledit empilement comprend en outre une cinquième couche de matériau semi-conducteur (153), à dopage de type N, disposée en contact sur ladite quatrième couche (152) de matériau semi-conducteur, ladite électrode de commande (16) étant disposée sur ladite cinquième couche de matériau semi-conducteur (153).

3. Transistor à effet de champ à hétérojonction (1) selon la revendication 2, dans lequel la deuxième électrode conductrice (15) s'étend jusqu'en contact avec la quatrième couche de matériau semi-conducteur (152).

4. Transistor à effet de champ à hétérojonction (1) selon la revendication 2 ou 3, dans lequel la cinquième couche en matériau semi-conducteur (153) présente une concentration en dopant supérieure à celle de la troisième couche en matériau semi-conducteur (151).

5. Transistor à effet de champ à hétérojonction (1) selon l'une quelconque des revendications précédentes, dans lequel ladite deuxième électrode conductrice (15) comporte un prolongement (157) s'étendant jusqu'en contact avec ladite première couche de matériau semi-conducteur (11), ladite deuxième électrode conductrice (15) comportant un contact Schottky avec ladite première couche de matériau semi-conducteur (11).

6. Transistor à effet de champ à hétérojonction (1) selon la revendication 5, dans lequel ladite électrode de commande (16) s'étend jusque dans la tranchée (18) traversant également la première couche de matériau semi-conducteur (11).

7. Transistor à effet de champ à hétérojonction (1) selon l'une quelconque des revendications précédentes, dans lequel les première et deuxième couches de matériau semiconducteur (11,12) sont formées en alliages de GaN respectifs.

8. Transistor à effet de champ à hétérojonction (1) selon l'une quelconque des revendications précédentes, dans lequel ladite couche de gaz d'électrons (13) s'étend en continu entre la première électrode conductrice (14) et la verticale à la troisième couche de matériau semi-conducteur (151).

9. Transistor à effet de champ à hétérojonction (1) selon l'une quelconque des revendications précédentes, dans lequel lesdites troisième et quatrième couches en matériaux semi-conducteurs sont formées en alliages de GaN respectifs.

10. Transistor à effet de champ à hétérojonction (1) selon l'une quelconque des revendications précédentes, dans lequel la troisième couche en matériau semi-conducteur présente une concentration en dopant supérieure à celle de la quatrième couche de matériau semi-conducteur (152).

11. Transistor à effet de champ à hétérojonction (1) selon l'une quelconque des revendications précédentes, dans lequel la troisième couche en matériau semi-conducteur (151) comprend un premier film (1511) en contact avec la deuxième couche de matériau semi-conducteur (12) et un deuxième film (1512) disposé entre le premier film et la quatrième couche de matériau semi-conducteur (152), le premier film (1511) présentant une concentration en dopant supérieure à celle du deuxième film.

12. Transistor à effet de champ à hétérojonction (1) selon l'une quelconque des revendications précédentes, dans lequel la deuxième électrode (15) recouvre la majeure partie de la quatrième couche de matériau semi-conducteur.

13. Transistor à effet de champ à hétérojonction (1) selon l'une quelconque des revendications précédentes, dans lequel la deuxième électrode (15) comprend une partie inférieure et une partie supérieure, la partie inférieure étant recouverte d'une couche de passivation (172), la deuxième électrode comportant un via (156) traversant la couche de passivation et reliant la partie inférieure et la partie supérieure.

14. Transistor à effet de champ à hétérojonction (1) selon la revendication 13, dans lequel la projection orthogonale de la partie supérieure de la deuxième électrode sur la deuxième couche de matériau semi-conducteur inclut la projection de la partie inférieure de la deuxième électrode sur la deuxième couche de matériau semi-conducteur.
